(19)

Europäisches
Patentamt
European
Patent Office
Office européen
des brevets

(11) **EP 2 680 450 A1**

(12) **EUROPEAN PATENT APPLICATION**
published in accordance with Art. 153(4) EPC

(43) Date of publication:
**01.01.2014 Bulletin 2014/01**

(21) Application number: **12749425.0**

(22) Date of filing: **23.02.2012**

(51) Int Cl.:
***H04B 1/16*** (2006.01)  ***H04J 11/00*** (2006.01)

(86) International application number:
**PCT/JP2012/054430**

(87) International publication number:
**WO 2012/115192 (30.08.2012 Gazette 2012/35)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **24.02.2011  JP 2011038469**

(71) Applicants:
• **NEC CASIO Mobile Communications, Ltd.
Kawasaki-shi
Kanagawa 211-8666 (JP)**

• **NTT Docomo, Inc.
Tokyo 100-6150 (JP)**

(72) Inventor: **ISHIDA, Kazuhiro
Kawasaki-shi, Kanagawa 211-8666 (JP)**

(74) Representative: **Vossius & Partner
Siebertstrasse 4
81675 München (DE)**

(54) **RECEIVING DEVICE, RECEIVING METHOD, AND COMPUTER PROGRAM**

(57)     Provided is a receiving device which, even when a temporary degradation occurs in the propagation path environment during an AFC tracking operation, does not require an initial lead-in operation when the propagation path environment returns to normal and which has lower power consumption and shortened time during which communication is not possible; also provided are a receiving method and a computer program. This receiving device calculates the variance of the phase rotation angle relative to a reference signal, compensating for frequency error if the rotation angle variance is less than a preset threshold value (TH), and stopping frequency error compensation if the rotation angle variance is greater than or equal to the threshold value (TH).

Fig.2

EP 2 680 450 A1

**Description**

{Technical Field}

The present invention relates to a receiver, a receiving method, and a computer program.

{Background Art}

In a wireless communication, Auto Frequency Control (hereinafter, called "AFC") is generally used as a technique for compensating a frequency error between a base station and a terminal, which is caused owing to a product variation and a temperature change with respect to a crystal oscillator (such as a Temperature-Compensated Crystal Oscillator (TCXO) and the like).

In a wireless communication system of Long Term Evolution (LTE) and the like, standardized by 3rd Generation Partnership Project (3GPP); considered is a method in which the amount of error is measured for correction by using the amount of phase rotation on a time axis of a synchronization signal and a reference signal.

In the method, a traceable range of the amount of phase rotation is limited to a range of +/-180 degrees. Long time intervals of signals, with which the amount of phase rotation is measured, lead to the large amount of phase rotation so that a range, in which a frequency error can be compensated, is narrowed. On the other hand, short time intervals mean measuring a small variation under a stable condition so that a measuring accuracy is reduced.

Therefore, conducted is a two-stage control; that is to say, since a frequency error is large in general at a stage before starting a communication between a terminal and a base station, measuring time intervals are narrowed in order to enable a larger acquisition (initial acquisition stage); and meanwhile, the measuring time intervals are widened after starting the communication stably, in order to increase an accuracy (tracking stage).

Traditionally, sometimes a statistics processing unit executes a variance computation process for monitoring a variation in a phase difference of a phase difference signal coming from a phase difference measuring unit; and when a variance value exceeds a criterion variance value, it is judged that most probably a wrong AFC control is conducted, and then changing an error signal for AFC is interrupted so as to stop an AFC function for maintaining an error signal based on phase difference information just before the stop (for example, refer to Patent Literature PTL 1).

{Citation List}

{Patent Literature}

PTL1: JP 2001-223610 A

{Summary of Invention}

{Technical Problem}

Unfortunately, there is a possibility that, in the case where a temporary degradation of a propagation path environment happens during a tracking operation after a start of communication, a frequency error cannot properly be measured any more so that a wrong compensation is carried out and an error exceeds a tracking range. In such a case, it is needed to execute an initial acquisition again. At the time, because an execution of the initial acquisition, there arise problems, such as the generation of a time period in which no communication can be done, an increase in power consumption, and the like.

Thus, it is an objective of the present invention to give a solution to the issue described above; namely to provide a receiver, a receiving method, and a computer program that eliminate the need of an initial acquisition after a propagation path environment restores its good condition even in the case where a temporary degradation of a propagation path environment happens during a tracking operation of AFC, in such a way as to make it possible to further reduce power consumption, and to further shorten a time period in which no communication can be done.

{Solution to Problem}

In order to give a solution to the issue described above, a receiving device according to the present invention includes: a variance calculation means for calculating a variance of inter-reference-signal phase rotation angles; and a frequency compensation means that compensates a frequency error if the variance of rotation angles is less than a predetermined first threshold, and interrupts an operation of compensating a frequency error if the variance of rotation angles is equal to or greater than the first threshold.

Moreover, a receiving method according to the present invention includes: a variance calculation step for calculating a variance of inter-reference-signal phase rotation angles; and a frequency compensation step that compensates a frequency error if the variance of rotation angles is less than a predetermined first threshold, and interrupts an operation of compensating a frequency error if the variance of rotation angles is equal to or greater than the first threshold.

Furthermore, a computer program according to the present invention to operate a computer for an operation includes a variance calculation step for calculating a variance of inter-reference-signal phase rotation angles; and a frequency compensation step that compensates a frequency error if the variance of rotation angles is less than a predetermined first threshold, and interrupts an operation of compensating a frequency error if the variance of rotation angles is equal to or greater than the first threshold.

{Advantageous Effects of Invention}

According to the present invention, it becomes possible to provide a receiver, a receiving method and a computer program that make it possible to further shorten a time period in which no communication can be done, and to further reduce power consumption.

{Brief Description of Drawings}

Fig. 1 is a block diagram showing a configuration example of a receiver.
Fig. 2 is a block diagram showing a configuration example of an AFC control unit 16.
Fig. 3 is a flowchart for explaining an example of a process of TCXO control.
Fig. 4 is a block diagram showing another configuration example of an AFC control unit 16.
Fig. 5 is a flowchart for explaining another example of a process of TCXO control.
Fig. 6 is a block diagram showing a configuration example of hardware of a computer.

{Description of Embodiments}

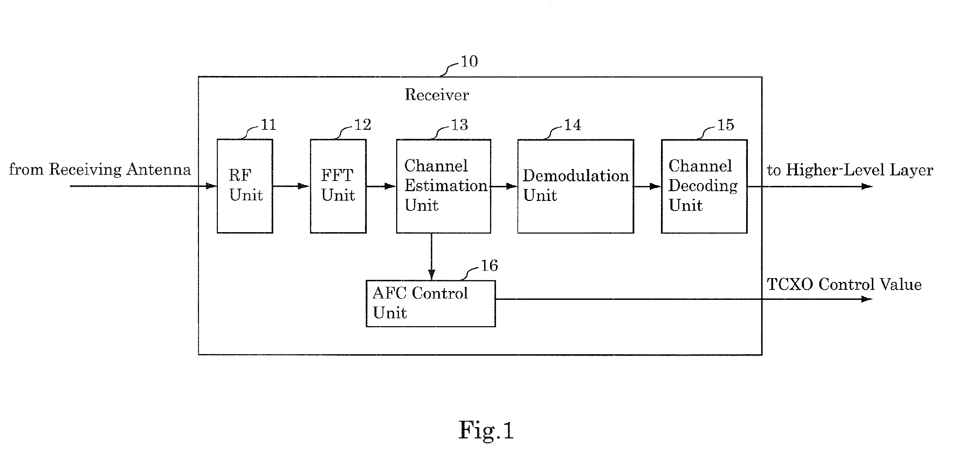

A receiver according to an exemplary embodiment of the present invention is explained below with reference to Fig. 1 through Fig. 6.

Fig. 1 is a block diagram showing a configuration example of a receiver. A receiver 10 receives a signal by way of a communication method specified by LTE. The receiver 10 includes a Radio Frequency (RF) unit 11, a Fast Fourier Transform (FFT) unit 12, a channel estimation unit 13, a demodulation unit 14, a channel decoding unit 15, and an AFC control unit 16.

A signal received by a receiving antenna (not shown) is supplied to the RF unit 11 of the receiver 10 (the signal received is hereinafter called a "received signal"). The RF unit 11 A/D-converts (to convert from Analog to Digital) the received signal, and supplies a digital signal obtained as a result of the A/D conversion, to the FFT unit 12. The FFT unit 12 transforms the digital signal into a datum of frequency components by way of a Fourier transform. Then, the FFT unit 12 supplies the datum of frequency components to the channel estimation unit 13.

The channel estimation unit 13 estimates a channel estimation matrix that expresses the channel status, by using a reference signal out of the datum of frequency components, the reference signal being mapped in advance on a frequency resource. Then, the channel estimation unit 13 supplies the channel estimation matrix to the demodulation unit 14 and the AFC control unit 16.

The demodulation unit 14 demodulates an I-component and Q-component into likelihood information, on the basis of the received signal, the channel estimation matrix estimated by the channel estimation unit 13, and the like. Then, the demodulation unit 14 supplies the likelihood information to the channel decoding unit 15. The channel decoding unit 15 carries out error correction decoding and error detection, and then supplies an obtained result to a higher-level layer.

Then, the AFC control unit 16 in the receiver 10 measures a frequency error on the basis of the channel estimation matrix estimated by the channel estimation unit 13, controls a crystal oscillator, and outputs a TCXO control value.

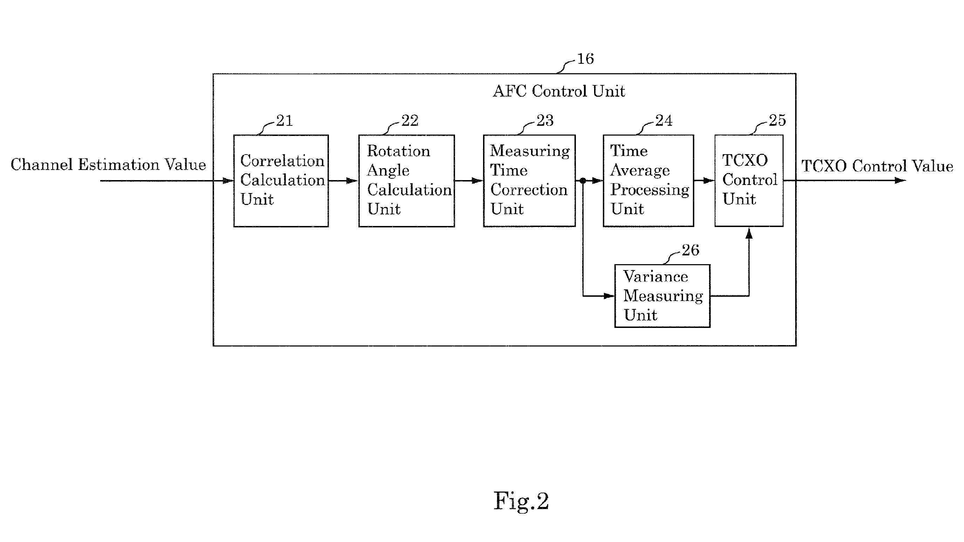

Fig. 2 is a block diagram showing a configuration example of the AFC control unit 16. The AFC control unit 16 includes a correlation calculation unit 21, a rotation angle calculation unit 22, a measuring time correction unit 23, a time average processing unit 24, a TCXO control unit 25, and a variance measuring unit 26.

The correlation calculation unit 21 calculates a correlation of RS according to Formula (1), wherein 'a' is a receiving antenna, 'b' is a transmission antenna, 't' is a time-wise direction index of a reference signal (hereinafter, also called "RS"), 'i' is a frequency-wise direction index of RS, and 'h (a, b, t, i)' is a channel estimation value corresponding to the above parameters.
{Math. 1}

$$V(a,b,t) = \frac{1}{N_{AFC}} \sum_{i=0}^{N_{AFC}-1} \left\{ \Theta \times h(a,b,t,i) \times h^*(a,b,t+1,i) \right\}$$

$$\cdots \text{Formula (1)}$$

Incidentally, an averaging number in a frequency-wise direction of RS is expressed by Formula (2).
{Math. 2}

$$N_{AFC}$$

$$\cdots \text{Formula (2)}$$

Meanwhile, a correction value on an amplitude & phase according to sampling of AGC & FFT is expressed by Formula (3).
{Math. 3}

$$\Theta$$

$$\cdots \text{Formula (3)}$$

The correlation calculation unit 21 supplies the correlation of RS: V (a, b, t) to the rotation angle calculation unit 22.
The rotation angle calculation unit 22 calculates an inter-RS rotation angle: θ(a, b, t) according to Formula (4), by using the correlation value: V (a, b, t) calculated by the correlation calculation unit 21.
{Math. 4}

$$\theta(a,b,t) = \arctan \mathrm{Im}(V(a,b,t)) / \mathrm{Re}(V(a,b,t))$$

$$\cdots \text{Formula (4)}$$

Incidentally, Im(c) and Re(c) in Formula (4) represent an imaginary part and a real part of a complex number c, respectively.
The rotation angle calculation unit 22 supplies the inter-RS rotation angle: θ(a, b, t) to the measuring time correction unit 23.
By using RS of a time-wise direction index t, a time difference T(t) of RS of a time-wise direction index t+1, and a criterion time T, the measuring time correction unit 23 adjusts the rotation angle: θ(a, b, t) with the criterion time T according to Formula (5).
{Math. 5}

$$\theta_T(a,b,t) = \frac{T}{T(t)} \theta(a,b,t)$$

$$\cdots \text{Formula (5)}$$

The measuring time correction unit 23 supplies the rotation angle adjusted with the criterion time T to the time average processing unit 24 and the variance measuring unit 26.

With respect to N sets of data of the rotation angle;

{Math. 6}

$$\theta_T(a,b,t)$$

the time average processing unit 24 calculates an average of their data according to Formula (6).

{Math. 7}

$$\overline{\theta}_T(a,b,t) = \frac{1}{N} \sum_{k=0}^{N} \theta_T(a,b,t+k)$$

$$\cdots \text{Formula (6)}$$

The average of N sets of data of the rotation angle;

{Math. 8}

$$\theta_T(a,b,t)$$

is supplied to the TCXO control unit 25 by the time average processing unit 24.

With respect to N sets of data of the rotation angle;

(Math. 9}

$$\theta_T(a,b,t)$$

the variance measuring unit 26 calculates a variance of their data according to Formula (7).

{Math. 10}

$$\sigma(a,b,t) = \frac{1}{N} \sum_{k=0}^{N} \left\{ \theta_T(a,b,t+k) \right\}^2 - \left\{ \frac{1}{N} \sum_{k=0}^{N} \theta_T(a,b,t+k) \right\}^2$$

$$\cdots \text{Formula (7)}$$

The variance of N sets of data of the rotation angle;

{Math. 11}

$$\theta_T(a,b,t)$$

is supplied to the TCXO control unit 25 by the variance measuring unit 26.

If the variance presented below, which the variance measuring unit 26 has calculated, is less than a threshold TH;

{Math. 12}

$$\sigma^2(a,b,t)$$

the TCXO control unit 25 calculates a TCXO control value, and conducts TCXO control.

In other words, the TCXO control unit 25 calculates a TCXO control value in this case by using the average of the rotation angle represented below, which the time average processing unit 24 has calculated;

{Math. 13}

$$\overline{\theta}_T(a,b,t)$$

and conducts TCXO control.

On the other hand, if the variance presented below is equal to or greater than the threshold TH;

{Math. 14}

$$\sigma^2(a,b,t)$$

the TCXO control unit 25 abandons a measurement result, and controls in such a way as not to change a frequency of the TCXO.

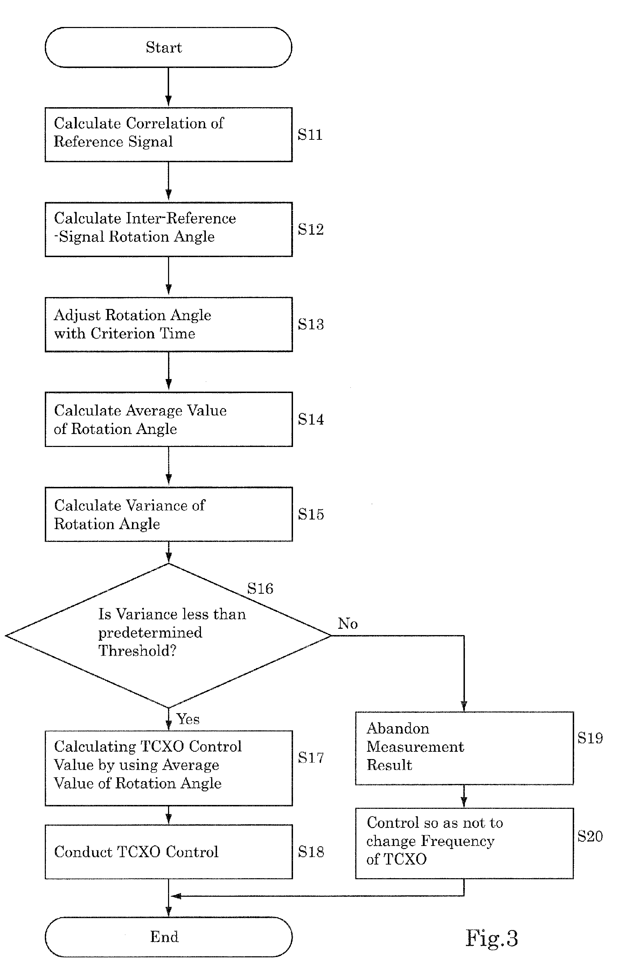

Fig. 3 is a flowchart for explaining an example of a process of TCXO control. At Step S11, the correlation calculation unit 21 calculates a correlation of RS according to Formula (1), by using a receiving antenna: a, a transmission antenna: b, a time-wise direction index of an RS: t, a frequency-wise direction index of RS: i, and a channel estimation value corresponding to the above parameters: h (a, b, t, i).

At Step S12, the rotation angle calculation unit 22 calculates an inter-RS rotation angle according to Formula (4), by using the correlation value calculated by the correlation calculation unit 21.

At Step S13, by using RS of a time-wise direction index t, a time difference T(t) of RS of a time-wise direction index t+1, and a criterion time T, the measuring time correction unit 23 adjusts the rotation angle with the criterion time T according to Formula (5).

At Step S14, the time average processing unit 24 calculates an average of N sets of data of the rotation angle, according to Formula (6).

At Step S15, the variance measuring unit 26 calculates a variance of N sets of data of the rotation angle, according to Formula (7).

At Step S16, the TCXO control unit 25 makes a judgment on whether or not the variance of N sets of data of the rotation angle is less than a threshold TH. If it is judged at Step S16 that the variance of N sets of data of the rotation angle is less than the threshold TH, operation progresses to Step S17 so that the TCXO control unit 25 calculates a TCXO control value by using the average of N sets of data of the rotation angle. At Step S18, the TCXO control unit 25 conducts TCXO control, and then the TCXO control ends.

If it is judged at Step S16 that the variance of N sets of data of the rotation angle is equal to or greater than the threshold TH, operation progresses to Step S19 so that the TCXO control unit 25 abandons a measurement result. Then, at Step S20, the TCXO control unit 25 controls in such a way as not to change a frequency of the TCXO, and the TCXO control ends.

Incidentally, the TCXO control may be conducted with reference to power of a correlation vector of a reference signal.

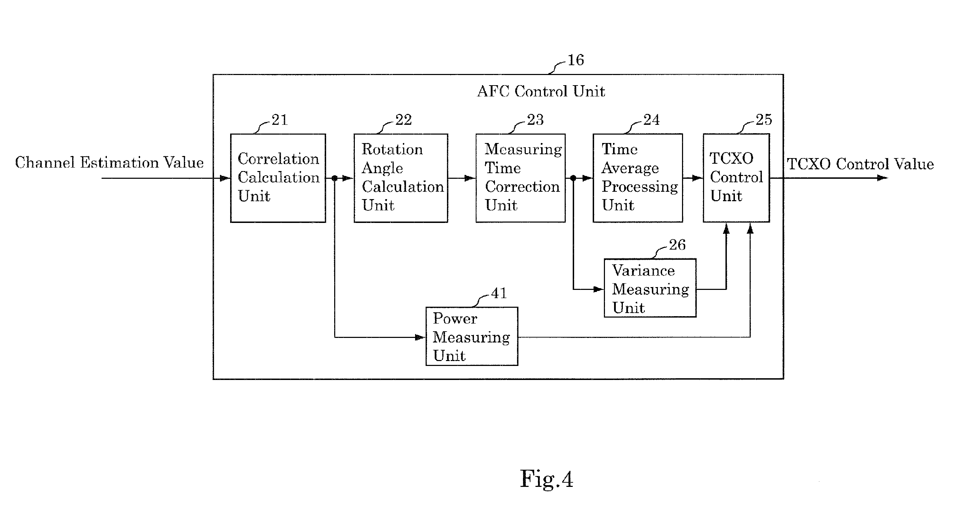

Fig. 4 is a block diagram showing another configuration example of an AFC control unit 16. The AFC control unit 16 shown in Fig. 4 includes a correlation calculation unit 21, a rotation angle calculation unit 22, a measuring time correction unit 23, a time average processing unit 24, a TCXO control unit 25, a variance measuring unit 26, and a power measuring unit 41. Since the correlation calculation unit 21 through the variance measuring unit 26 are the same as those in the case that Fig. 2 shows, explanation on them is skipped.

The correlation calculation unit 21 supplies a correlation of RS, calculated according to Formula (1), to the rotation angle calculation unit 22 and the power measuring unit 41.

By using the correlation vector presented below, which has been calculated by the correlation calculation unit 21;

$$\{\text{Math. 15}\}$$

$$V(a,b,t)$$

the power measuring unit 41 calculates a power average according to Formula (8).

{Math. 16}

$$P(a,b,t) = \frac{1}{N} \sum_{k=0}^{N} |V(a,b,t+k)|^2$$

$$\cdots \text{Formula (8)}$$

The power measuring unit 41 supplies the power average: P (a, b, t) to the TCXO control unit 25.

With respect to the variance presented below, which has been calculated by the variance measuring unit 26;

$$\{\text{Math. 17}\}$$

$$\sigma^2(a,b,t)$$

only if the variance is less than a threshold TH and the power average: P (a, b, t) calculated by the power measuring unit 41 is greater than a power threshold THP, the TCXO control unit 25 calculates a TCXO control value and conducts TCXO control.

In other words, the TCXO control unit 25 calculates a TCXO control value in this case by using the average of the rotation angle represented below, which the time average processing unit 24 has calculated;

$$\{\text{Math. 18}\}$$

$$\overline{\theta}_T(a,b,t)$$

and conducts TCXO control.

If the variance presented below is equal to or greater than the threshold TH;

$$\{\text{Math. 19}\}$$

$$\sigma^2(a,b,t)$$

the TCXO control unit 25 abandons a measurement result, and controls in such a way as not to change a frequency of the TCXO.

Moreover, if the power average: P (a, b, t) calculated by the power measuring unit 41 is equal to or less than the power threshold THP, the TCXO control unit 25 abandons a measurement result, and controls in such a way as not to change a frequency of the TCXO.

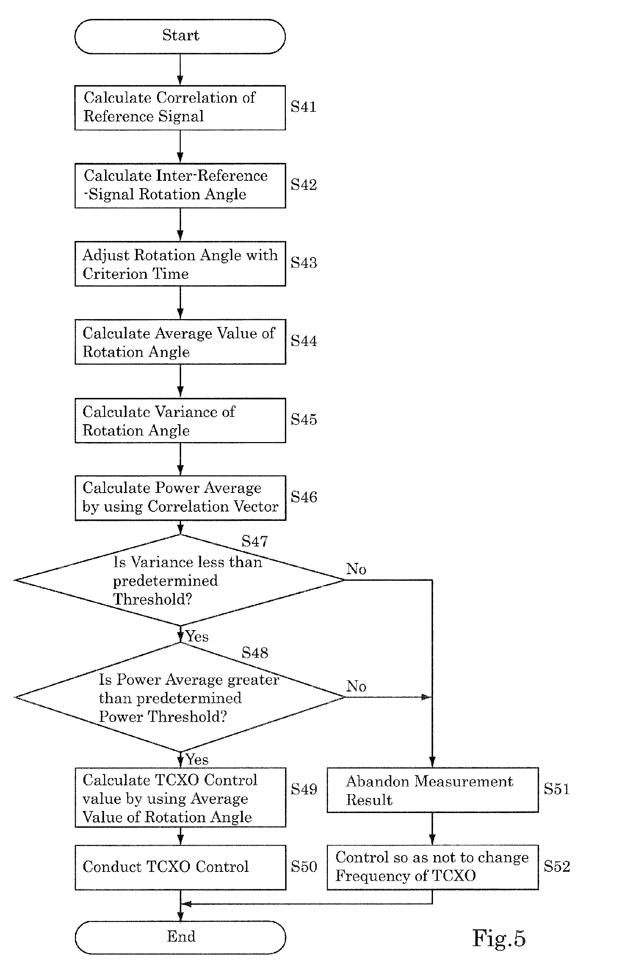

Fig. 5 is a flowchart for explaining another example of a process of TCXO control. Since procedures of Step S41 through Step S45 are the same as those of Step S11 through Step S15 in Fig. 3, respectively, explanation on them is skipped.

At Step S46, the power measuring unit 41 calculates a power average: P (a, b, t) according to Formula (8), by using a correlation vector calculated by the correlation calculation unit 21.

At Step S47, the TCXO control unit 25 makes a judgment on whether or not the variance of N sets of data of the rotation angle is less than a threshold TH. If it is judged at Step S47 that the variance of N sets of data of the rotation angle is less than the threshold TH, operation progresses to Step S48 so that the TCXO control unit 25 makes a judgment on whether or not the power average: P (a, b, t) is greater than the power threshold THP.

If it is judged at Step S48 that the power average: P (a, b, t) is greater than the power threshold THP, operation progresses to Step S49, and the TCXO control unit 25 calculates a TCXO control value by using the average of N sets of data of the rotation angle. At Step S50, the TCXO control unit 25 conducts TCXO control, and then the TCXO control ends.

If it is judged at Step S47 that the variance of N sets of data of the rotation angle is equal to or greater than the threshold TH, or if it is judged at Step S48 that the power average: P (a, b, t) is equal to or less than the power threshold THP, operation progresses to Step S51 so that the TCXO control unit 25 abandons a measurement result. Then, at Step S52, the TCXO control unit 25 controls in such a way as not to change a frequency of the TCXO, and the TCXO control ends.

Incidentally, in order to reduce the amount of processing operation, the variation may be calculated only in the case of power being great.

Even in the case where a temporary degradation of a propagation path environment happens during a tracking operation of AFC, an initial acquisition, after a propagation path environment restores its good condition, becomes unnecessary so that it becomes possible to reduce power consumption, and to shorten a time period in which no communication can be done.

Thus, reliability (variance) of the amount of phase rotation measured is calculated, and a compensating operation of frequency is interrupted if the calculated value is equal to or greater than a threshold.

As described above, it is detected that reliability of the frequency error measurement is lowered due to a temporary degradation of a propagation path environment, and a control operation of frequency compensation in such a case is interrupted. Thus, a frequency error is kept away from becoming large, and a tracking operation can be done without executing an initial acquisition again, after a propagation path environment is restored.

The series of processes described above may be executed by means of hardware, and may also be executed by way of software. For executing the series of processes by way of software, a computer program constituting the software is installed into a computer, which is built in exclusive-use hardware, from a recording medium; or the software is installed from a recording medium, for example, into a general-purpose personal computer that can execute various functions with various computer programs being installed.

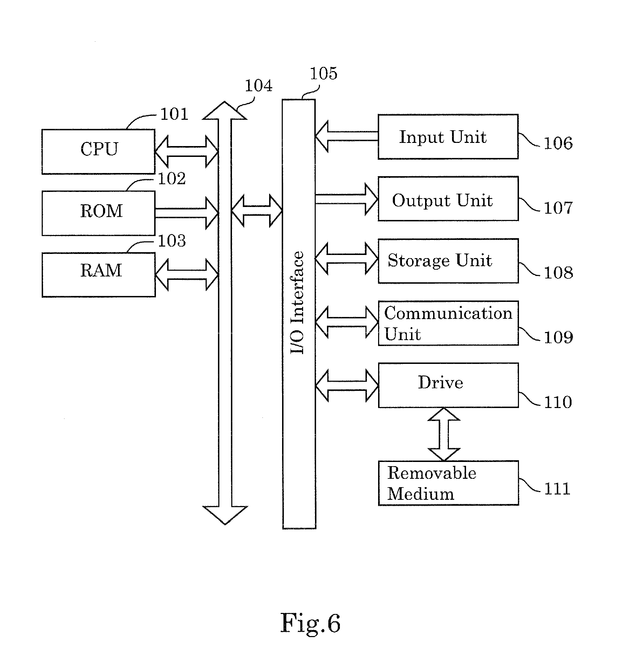

Fig. 6 is a block diagram showing a configuration example of hardware of a computer that executes the series of processes described above by way of a computer program.

In the computer; a central processing unit (CPU) 101, a read only memory (ROM) 102, and a random access memory (RAM) 103 are interconnected by using a bus 104.

Moreover, an I/O interface 105 is connected to the bus 104. Connected to the I/O interface 105 are; an input unit 106 including a keyboard, a mouse, a microphone, and the like; an output unit 107 including a display, a speaker, and the like; a storage unit 108 including a hard disc, a non-volatile memory, and the like; a communication unit 109 including a network interface and the like; and a drive 110 for driving a removable medium 111 such as a magnetic disc, an optical disc, a magnetic optical disc, or a semiconductor memory.

In the computer configured as described above, the CPU 101 loads a computer program, for example, stored in the storage unit 108, to the RAM 103 by way of the I/O interface 105 and the bus 104, and executes the program in order to carry out the series of processes described above.

The computer program to be executed by the computer (the CPU 101) is recorded, for being provided, in the removable medium 111 as a package medium; such as, for example, a magnetic disc (including a flexible disc), an optical disc (Compact Disc - Read Only Memory (CD-ROM), Digital Versatile Disc (DVD), and the like), a magnetic optical disc, or a semiconductor memory; or the computer program is provided via a wired or wireless transmission medium such as a local area network, the Internet, or digital satellite broadcasting.

Then, the computer program can be installed in the computer by way of being stored in the storage unit 108 through the I/O interface 105, while the removable medium 111 being mounted on the drive 110. Alternatively, the computer program can be installed in the computer by way of being stored in the storage unit 108, while being received in the communication unit 109 by the intermediary of a wired or wireless transmission medium. In another way, the computer program can previously be installed in the computer by way of storing the program in advance in the ROM 102 or the storage unit 108.

Incidentally, the program to be executed by the computer may be a program with which processes are carried out in chronological order along the sequence explained in this specification document, or may be a computer program with which processes are carried out in parallel or at the time as required, such as, in response to a call.

Furthermore, an embodiment of the present invention is not limited only to the embodiment described above, and various other variations may be made without departing from the concept of the present invention.

{Reference Signs List}

|  |  |
|---|---|
| 10. receiver    11. RF unit | 12. FFT unit |
| 13. channel estimation unit | 14. demodulation unit |
| 15. channel decoding unit | 16. AFC control unit |
| 21. correlation calculation unit | 22.rotation angle calculation unit |
| 23. measuring time correction unit | 24. time average processing unit |
| 25. TCXO control unit | 26. variance measuring unit |
| 41. power measuring unit | |
| 101. CPU    102. ROM    103. RAM | 108. storage unit |
| 109. communication unit | 111. removable medium |

**Claims**

1. A receiver comprising:

   a variance calculation means for calculating a variance of inter-reference-signal phase rotation angles; and
   a frequency compensation means that compensates a frequency error if the variance of rotation angles is less than a predetermined first threshold, and interrupts an operation of compensating a frequency error if the variance of rotation angles is equal to or greater than the first threshold.

2. The receiver according to claim 1, further comprising:

   a power calculation means for calculating power of a correlation vector of a reference signal;
   wherein the frequency compensation means compensates a frequency error if the variance of rotation angles is less than the predetermined first threshold and the power of a correlation vector is greater than a predetermined second threshold, and the frequency compensation means interrupts the operation of compensating a frequency error if the variance of rotation angles is equal to or greater than the first threshold, or if the power of a correlation vector is equal to or less than the second threshold.

3. A receiving method comprising:

   a variance calculation step for calculating a variance of inter-reference-signal phase rotation angles; and
   a frequency compensation step that compensates a frequency error if the variance of rotation angles is less than a predetermined first threshold, and interrupts an operation of compensating a frequency error if the variance of rotation angles is equal to or greater than the first threshold.

4. A computer program to operate a computer for an operation  comprising:

   a variance calculation step for calculating a variance of inter-reference-signal phase rotation angles; and
   a frequency compensation step that compensates a frequency error if the variance of rotation angles is less than a predetermined first threshold, and interrupts an operation of compensating a frequency error if the variance of rotation angles is equal to or greater than the first threshold.

Fig.1

Fig.2

11

```
                        ┌─────────────────┐
                        │      Start      │
                        └────────┬────────┘
                                 │
                                 ▼
              ┌──────────────────────────────┐
              │ Calculate Correlation of     │  S11
              │ Reference Signal             │
              └──────────────┬───────────────┘
                             │
                             ▼
              ┌──────────────────────────────┐
              │ Calculate Inter-Reference    │  S12
              │ -Signal Rotation Angle       │
              └──────────────┬───────────────┘
                             │
                             ▼
              ┌──────────────────────────────┐
              │ Adjust Rotation Angle        │  S13
              │ with Criterion Time          │
              └──────────────┬───────────────┘
                             │
                             ▼
              ┌──────────────────────────────┐
              │ Calculate Average Value      │  S14
              │ of Rotation Angle            │
              └──────────────┬───────────────┘
                             │
                             ▼
              ┌──────────────────────────────┐
              │ Calculate Variance of        │  S15
              │ Rotation Angle               │
              └──────────────┬───────────────┘
                             │
                             ▼
```

S16

Is Variance less than predetermined Threshold?

No

Yes

| S17 | Calculating TCXO Control Value by using Average Value of Rotation Angle |

| S18 | Conduct TCXO Control |

| S19 | Abandon Measurement Result |

| S20 | Control so as not to change Frequency of TCXO |

End

Fig.3

**Fig.4**

AFC Control Unit 16

Channel Estimation Value →

21 Correlation Calculation Unit

22 Rotation Angle Calculation Unit

23 Measuring Time Correction Unit

24 Time Average Processing Unit

25 TCXO Control Unit

26 Variance Measuring Unit

41 Power Measuring Unit

→ TCXO Control Value

```
                    ┌──────────────────┐
                    │      Start       │
                    └──────────────────┘
                             │
                             ▼
              ┌──────────────────────────┐
              │ Calculate Correlation of │ S41
              │ Reference Signal         │
              └──────────────────────────┘
                             │
                             ▼
              ┌──────────────────────────┐
              │ Calculate Inter-Reference│ S42
              │ -Signal Rotation Angle   │
              └──────────────────────────┘
                             │
                             ▼
              ┌──────────────────────────┐
              │ Adjust Rotation Angle with│ S43
              │ Criterion Time           │
              └──────────────────────────┘
                             │
                             ▼
              ┌──────────────────────────┐
              │ Calculate Average Value of│ S44
              │ Rotation Angle           │
              └──────────────────────────┘
                             │
                             ▼
              ┌──────────────────────────┐
              │ Calculate Variance of    │ S45
              │ Rotation Angle           │
              └──────────────────────────┘
                             │
                             ▼
              ┌──────────────────────────┐
              │ Calculate Power Average  │ S46
              │ by using Correlation Vector│
              └──────────────────────────┘
```

S47

Is Variance less than predetermined Threshold?  — No

Yes

S48

Is Power Average greater than predetermined Power Threshold?  — No

Yes

Calculate TCXO Control value by using Average Value of Rotation Angle    S49

Abandon Measurement Result    S51

Conduct TCXO Control    S50

Control so as not to change Frequency of TCXO    S52

End

Fig.5

Fig.6

## INTERNATIONAL SEARCH REPORT

| | International application No. |
|---|---|
| | PCT/JP2012/054430 |

**A. CLASSIFICATION OF SUBJECT MATTER**
*H04B1/16*(2006.01)i, *H04J11/00*(2006.01)i

According to International Patent Classification (IPC) or to both national classification and IPC

**B. FIELDS SEARCHED**

Minimum documentation searched (classification system followed by classification symbols)
H04B1/16, H04J11/00

Documentation searched other than minimum documentation to the extent that such documents are included in the fields searched
| Jitsuyo Shinan Koho | 1922–1996 | Jitsuyo Shinan Toroku Koho | 1996–2012 |
| Kokai Jitsuyo Shinan Koho | 1971–2012 | Toroku Jitsuyo Shinan Koho | 1994–2012 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>Y | JP 2001-223610 A  (Sharp Corp.),<br>17 August 2001 (17.08.2001),<br>paragraphs [0021] to [0046]; fig. 1 to 7<br>(Family: none) | 1,3,4<br>2 |
| Y | JP 2009-171266 A  (NEC Corp.),<br>30 July 2009 (30.07.2009),<br>paragraphs [0010] to [0049]; fig. 1 to 6<br>(Family: none) | 2 |

☐ Further documents are listed in the continuation of Box C.     ☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>25 April, 2012 (25.04.12) | Date of mailing of the international search report<br>15 May, 2012 (15.05.12) |
|---|---|
| Name and mailing address of the ISA/<br>Japanese Patent Office | Authorized officer |
| Facsimile No. | Telephone No. |

Form PCT/ISA/210 (second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• JP 2001223610 A